# EUROPEAN PATENT APPLICATION

(11) **EP 3 247 182 A1**
(43) Date of publication of application: **22.11.2017**
(21) Application number: 16737192.1
(22) Date of filing: 08.01.2016
(51) Int. Cl.: H05K 3/12, H05K 1/09, H05K 3/46

(54) **METHOD FOR MANUFACTURING CERAMIC SUBSTRATE, CERAMIC SUBSTRATE, AND SILVER-BASED CONDUCTOR MATERIAL**

(30) Priority: 13.01.2015 JP 2015003819
(71) Applicant: NGK Spark Plug Co., Ltd., Nagoya-shi, Aichi 467-8525 (JP)
(72) Inventor: KATOH, Tatsuya, Nagoya-shi Aichi 467-8525 (JP); ITO, Masanori, Nagoya-shi Aichi 467-8525 (JP); KUTSUNA, Masaki, Nagoya-shi Aichi 467-8525 (JP)
(74) Representative: Grünecker Patent- und Rechtsanwälte PartG mbB
(86) International application number: PCT/JP2016/000082
(87) International publication number: WO 2016/114121

(57) **Abstract**

A method for manufacturing a ceramic substrate containing glass, the method being provided with a firing step in which an unfired silver-based conductor material is arranged in an unfired ceramic layer and then fired, and the unfired silver-based conductor material containing a metal boride and/or a metal silicide

## Description

### TECHNICAL FIELD

The present invention relates to a method for manufacturing a ceramic substrate, a ceramic substrate, and a silver-based conductor material.

### BACKGROUND ART

There has been known a multi-layer ceramic substrate fired at a low temperature, which is also called a low temperature co-fired ceramic (LTCC) substrate. Such an LTCC substrate is usually manufactured by laminating a plurality of green sheets, each having a wiring trace formed of an unfired conductor material, and firing the green sheets (for example, see the following Patent Documents 1 and 2, etc.).

### PRIOR ART DOCUMENTS

### PATENT DOCUMENTS

Patent Document 1: Japanese Patent Application Laid-Open *(kokai)* No. H6-252524
Patent Document 2: Japanese Patent Application Laid-Open *(kokai)* No. 2007-234537

### SUMMARY OF THE INVENTION

### PROBLEM TO BE SOLVED BY THE INVENTION

A process of manufacturing a ceramic substrate using a silver-based conductor material, not limited to the above-mentioned LTCC substrate, has a problem of diffusion of silver contained in the conductor material into the ceramic during firing. This may cause formation of voids in the substrate, deformation of the substrate, and change of the color of the substrate. Conventionally, there have been proposed techniques of adding various substances to the silver-based conductor material so as to prevent diffusion of silver during firing. For example, Patent Document 1 discloses a technique of coating the surfaces of the particles of a silver-based conductor powder with an antimony salt or an antimonate salt. Patent Document 2 discloses a technique of adding a silicon (Si) powder to a conductor paste.

However, even when such a substance is added to the silver-based conductor material, the effect of preventing silver diffusion cannot be attained to a sufficient degree in the case where a reaction caused by the added substance to prevent diffusion of silver does not occur as expected at temperatures near the firing temperature. Thus, there is still a room for improvement regarding prevention of diffusion of silver during firing in the process of manufacturing such a ceramic substrate.

### MEANS FOR SOLVING THE PROBLEM

The present invention has been accomplished to solve at least the above-described problem by employing a method different from conventional ones. The present invention can be realized as the following modes.

[1] One mode of the present invention is a method for manufacturing a ceramic substrate containing glass. The manufacturing method includes a firing step. The firing step may be a step of firing an unfired ceramic layer and an unfired silver-based conductor material disposed on the unfired ceramic layer. The unfired silver-based conductor material may contain at least one of a metal boride and a metal silicide. The manufacturing method of this mode prevents diffusion of silver during firing because at least one of a metal boride and a metal silicide is added in the unfired silver-based conductor material. The unfired silver-based conductor material may be disposed on a surface of an unfired ceramic layer, between unfired ceramic layers adjacent to each other, or in through holes formed in an unfired ceramic layer.
[2] In the manufacturing method of the above-mentioned mode, the metal boride may be at least one of lanthanum hexaboride, silicon hexaboride, titanium diboride, and tantalum diboride. The manufacturing method of this mode prevents diffusion of silver during firing more effectively.
[3] In the manufacturing method of the above-mentioned mode, the metal silicide may be at least one of titanium disilicide, zirconium disilicide, tungsten disilicide, chromium disilicide, molybdenum disilicide, and tantalum disilicide. The manufacturing method of this mode prevents diffusion of silver during firing more effectively.
[4] In the manufacturing method of the above-mentioned mode, the unfired silver-based conductor material contains the metal boride or the metal silicide. The amount of the metal boride or the metal silicide with respect to the amount of the inorganic components of the unfired silver-based conductor material may be greater than 3 vol.% and less than 20 vol.%. The manufacturing method of this mode prevents diffusion of silver during firing more effectively and also prevents impurities from remaining in the conductor of the substrate.
[5] In the manufacturing method of the above-mentioned mode, the unfired silver-based conductor material contains a silver powder and at least one of the metal boride and the metal silicide may be attached to surfaces of particles of the silver powder in the silver-based conductor material. The manufacturing method of this mode prevents oxidation of silver during firing more effectively. As a result, the effect of preventing diffusion of silver into a ceramic layer improves.
[6] A second mode of the present invention is a ceramic substrate. The ceramic substrate may include a ceramic layer and a wiring layer of a sliver-based conductor which are formed by the firing step according to any one of the manufacturing methods of the above-mentioned mode. The ceramic substrate of this mode prevents problems such as formation of voids in the ceramic substrate, warpage of the ceramic substrate, change of the color of the ceramic substrate, etc.
[7] A third mode of the present invention is a silver-based conductor material which is unfired and fired together with an unfired ceramic layer to form a wiring layer in a ceramic substrate. The silver-based conductor material of this mode may contain at least one of a metal boride and a metal silicide. The silver-based conductor material of this mode prevents diffusion of silver in a process of manufacturing a ceramic substrate. In the silver-based conductor material of this mode, the metal boride may be at least one of lanthanum hexaboride, silicon hexaboride, titanium diboride, and tantalum diboride. In the silver-based conductor material of this mode, the metal silicide may be at least one of titanium disilicide, zirconium disilicide, tungsten disilicide, chromium disilicide, molybdenum disilicide, and tantalum disilicide.

All the plurality of constituent elements of each mode of the present invention are not essential. In order to solve, partially or entirely, the above-mentioned problem or yield, partially or entirely, the effects described in the present specification, a part of the elements may be properly modified, deleted, or replaced with another new element, or the limitation thereof may be partially removed. Also, in order to solve, partially or entirely, the above-mentioned problem or yield, partially or entirely, the effects described in the present specification, a portion or all of the above-described technical features contained in one mode of the present invention may be combined with a portion or all of the above-described technical features contained in other modes of the present invention to thereby attain an independent mode of the present invention.

The present invention can be realized as various modes other than a method for manufacturing a ceramic substrate, a ceramic substrate, or a silver-based conductor material. For example, the present invention can be realized as a method for firing a ceramic substrate, a method for manufacturing a silver-based conductor material, an apparatus for implementing those methods, etc.

### BRIEF DESCRIPTION OF THE DRAWINGS

[FIG. 1] Schematic view showing a structure of an LTCC substrate.
[FIG. 2] Flowchart showing steps of a process of manufacturing the LTCC substrate.
[FIG. 3] Explanatory view showing the results of an experiment for checking an effect of preventing diffusion of silver by adding an additive to a conductor paste.
[FIG. 4] Explanatory views showing scanning electron microscope (SEM) images of LTCC substrates and images showing the silver concentration distribution profile in each of the LTCC substrates.

### MODES FOR CARRYING OUT THE INVENTION

### A. Embodiment

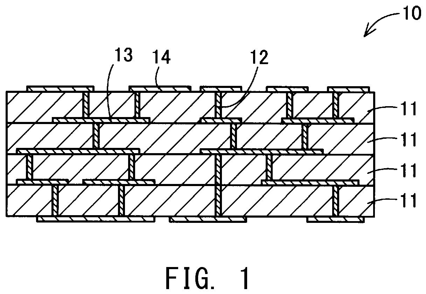

FIG. 1 is a schematic view showing the structure of an LTCC substrate 10 according to one embodiment of the present invention. The LTCC substrate 10 which is a ceramic substrate is used, for example, for electronic components, high-frequency modules, IC packages, or printed wiring boards used in computers, communication devices, etc. The LTCC substrate 10 has a multi-layer structure formed by laminating a plurality of ceramic insulating layers 11. Each of the ceramic insulating layers 11 is formed by low temperature firing whose firing temperature is 1000°C or lower.

Each of the ceramic insulating layers 11 has vias which are through holes for disposing via electrodes 12. The LTCC substrate 10 has wiring layers including internal electrodes 13 and external electrodes 14, each formed between ceramic insulating layers 11 adjacent to each other. The wiring layers are electrically connected to one another through the via electrodes 12 formed in the ceramic insulating layers 11.

In the LTCC substrate 10 of the present embodiment, each of the electrodes 12 to 14 is formed of a silver-based conductor material whose main component is silver. In this description, a "main component" means a material component which accounts for at least 50 mass% of the mixture. On the outermost surface of the LTCC substrate 10 are disposed passive elements (resistors, etc.) and active elements (ICs, etc.) which are connected to the external electrodes 14. In this description, illustration and detailed description of the passive elements and the active elements are omitted.

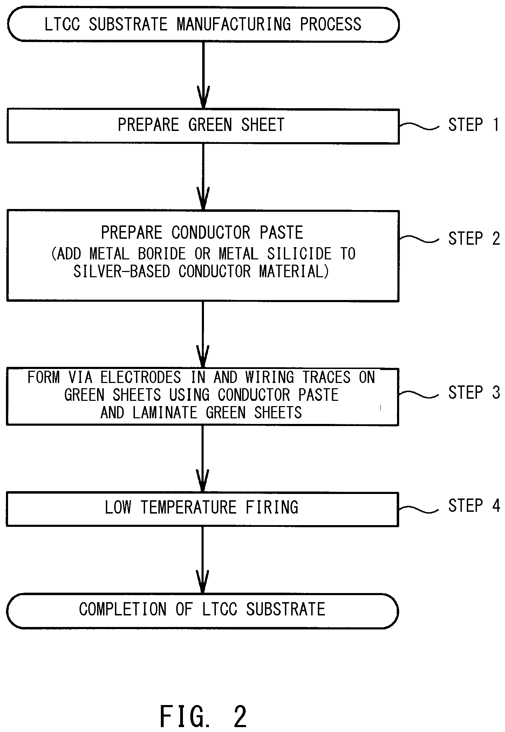

FIG. 2 is a flowchart showing steps of a process of manufacturing the LTCC substrate 10. The LTCC substrate 10 is manufactured by firing an unfired ceramic material (green sheet) and an unfired silver-based conductor material together at low temperature.

In step 1, a green sheet which constitutes an unfired ceramic layer containing ceramic particles and glass particles is prepared. The green sheet is made by preparing a ceramic slurry by mixing together inorganic components (including a glass powder and an inorganic filler), a binder component, a plasticizer, and a solvent, and forming the ceramic slurry into the shape of a sheet using the doctor blade method or the like.

In step 2, a conductor paste which forms electrodes 12 to 14 and which is an unfired silver-based conductor material is prepared. The conductor paste is made by mixing together a powder of the silver-based material and a glass powder which are inorganic components, and an organic solvent and a resin which is a varnish component.

Notably, the inventor of the present invention has found that adding at least one of a metal boride and a metal silicide into the conductor paste as an inorganic component prevents diffusion of silver contained in the conductor paste, or a silver component of the conductor paste, into the ceramic insulating layer during a firing step described later. It is considered that oxygen present near the conductor paste is consumed by oxidation of the metal boride or the metal silicide during the firing step, whereby oxidation of the silver contained in the conductor paste is prevented.

In step 2 of the present embodiment, an additive including at least one of a metal boride and a metal silicide is added to the conductor paste. For example, the following substances can be used as an additive to be added to the conductor paste.

Examples of the metal boride include lanthanum hexaboride (LaB₆), silicon hexaboride (SiB₆), titanium diboride (TiB₂), tantalum diboride (TaB₂), niobium diboride (NbB₂), chromium diboride (CrB₂), molybdenum boride (MoB), zirconium diboride (ZrB₂), tungsten boride (WB), vanadium diboride (VB₂), and hafnium diboride (HfB₂). Examples of the metal silicide include zirconium disilicide (ZrSi₂), titanium disilicide (TiSi₂), tungsten disilicide (WSi₂), molybdenum disilicide (MoSi₂), tantalum disilicide (TaSi₂), chromium disilicide (CrSi₂), niobium disilicide (NbSi₂), iron disilicide (FeSi₂), and hafnium disilicide (HfSi₂).

The metal borides and the metal silicides described above are just examples. The additive may be a metal boride or a metal silicide other than those described above. However, the metal boride or the metal silicide used as an additive is preferably a one which initiates a reaction with oxygen during the firing step described later. In particular, the metal boride or the metal silicide preferably has an oxidation temperature which is lower than the firing temperature during the firing step 4 described later. The "oxidation temperature" is a peak temperature at which oxidation occurs, and is a value measured through thermogravimetric-differential thermal analysis (TG-DTA). Specifically, the oxidation temperature of the metal boride or the metal silicide as an additive is preferably 800°C or lower, and more preferably 700°C or lower. Also, the oxidation temperature of the metal boride or the metal silicide as an additive is preferably 400°C or higher, and more preferably 500°C or higher. Diffusion of silver is prevented if the oxidized silver is not wetted by the glass material contained in the green sheet when the glass material softens during the firing step. For this reason, the oxidation temperature of the metal boride or the metal silicide as an additive is preferably lower than the glass-transition temperature of the glass material contained in the green sheet prepared in step 1.

The additive may be added in the form of powder, for example, concurrently with or after the step of mixing the inorganic components and the varnish components. Alternatively, the additive may be added before mixing the inorganic components and the varnish components. In this case, the additive is added in such a manner that the surfaces of the particles of the silver-based material contained in the inorganic components are coated with the additive. For example, the silver-based material can be coated with the additive by the following method. First, the additive is dissolved or dispersed in an organic solvent (toluene, xylene, or alcohol). Then, a powder of the silver-based material is dispersed or suspended in the solution or dispersion of the additive. The solvent is kept still for a predetermined time or stirred so as to cause the additive to adhere to the surfaces of the particles of the silver-based material. Coating the silver-based material with the additive as described prevents oxidation of silver to a greater degree, and improves the effect of silver diffusion. The additive may be added to the conductor paste using a method other than that described above.

The amount of additive with respect to the amount of the inorganic components of the conductor paste is preferably more than 3 vol.%, more preferably more than 5 vol.%. This condition allows the effect of silver diffusion to be attained more reliably. The amount of additive with respect to the conductor paste is preferably less than 20 vol.%, more preferably less than 18 vol.%. This condition prevents impurities originating from the additive in the conductor paste from remaining in the LTCC substrate 10 after firing.

In step 3, the above-described conductor paste is disposed on the green sheet. Specifically, vias are formed in the green sheet by a hole-making operation such as punching, and the vias are filled with the conductor paste. A wiring trace is printed on each surface of the green sheet by applying the conductor paste thereto by means of screen printing or the like. After the wiring trace is formed, a plurality of such green sheets are laminated to form an unfired laminate.

In step 4, the unfired laminate is fired at a low temperature. The firing temperature in step 4 may be a temperature preset in accordance with the glass-transition temperature of the material component of the green sheet prepared in step 1. Specifically, the firing temperature in step 4 may be, for example, approximately 750°C to 950°C. After step 4, the LTCC substrate 10 is completed. Passive elements and active elements to be connected to the electrodes 14 are disposed on the completed LTCC substrate 10.

As described above, in the LTCC substrate 10 of the present embodiment, addition of the metal boride or the metal silicide to the conductor paste in step 2 prevents diffusion of silver from the silver-based conductor material to the ceramic insulating layer 11. This prevents deterioration of electrical insulation of the ceramic insulating layers 11 caused by diffusion of silver. Local change of the color of the ceramic caused by a change in the composition of the ceramic near the wiring trace as well as local deterioration of the strength of the ceramic insulating layer 11 are also prevented. In addition, acceleration of firing-caused contraction only near the conductor paste is prevented, and formation of voids between the electrodes 12 to 14 and the ceramic insulating layers 11 are prevented.

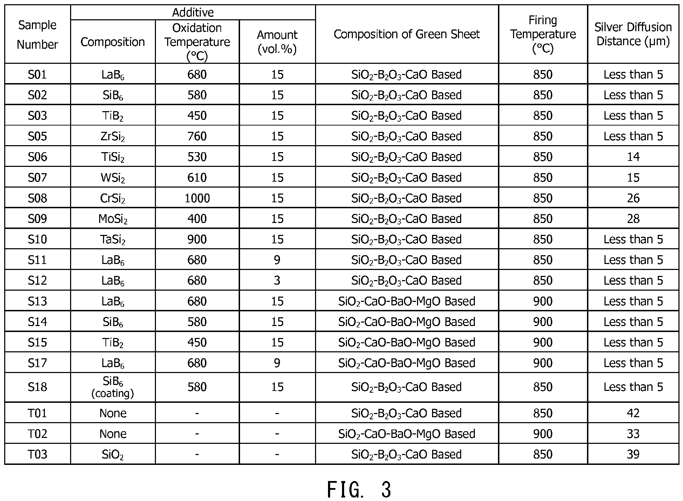

FIG. 3 is an explanatory view showing the results of an experiment for checking an effect of preventing diffusion of silver by adding the additive to the conductor paste. This experiment checked diffusion of silver into the ceramic insulating layers using samples S01 to S18 (missing numbers: S04 and S16) of LTCC substrates manufactured through use of a conductor paste containing an additive and samples T01 to T03 of the LTCC substrates manufactured through use of a conductor paste containing no additive. The specific conditions for manufacturing samples S01 to S18 (missing numbers: S04 and S16) and T01 to T03 are as follows.

### <Compositions of the green sheets>

For samples S01 to S03, S05 to S12, S18, T01, and T03, green sheets containing an SiO₂-B₂O₃-CaO glass and alumina (Al₂O₃) were prepared. For samples S13 to S15, S17, and T02, green sheets containing an SiO2-CaO-BaO-MgO glass and alumina (Al₂O₃) were prepared.

### <Procedure for preparing the green sheets>

(1) A powder of borosilicate-based glass whose main components are silica (SiO₂), alumina (Al₂O₃), and boric acid (H₃BO₃) and a powder of alumina were put into a pot formed of alumina such that their volume ratio became 60:40 and the total weight became 1 kg.
(2) Subsequently, 120 g of acrylic resin and proper amounts of methyl ethyl ketone (MEK) serving as a solvent and dioctyl phthalate (DOP) serving as a plasticizer were put into the pot formed of alumina. The amounts of methyl ethyl ketone and dioctyl phthalate were determined such that the desired levels of slurry viscosity and sheet strength could be attained.
(3) The materials mentioned above were mixed for five hours to thereby obtain a ceramic slurry.
(4) A green sheet with a thickness of 0.15 mm was made from the ceramic slurry using the doctor blade method.

### <Conductor paste>

### (1) Conductor pastes for samples S01 to S17 (missing numbers: S04 and S16)

A mixture of the following inorganic components, varnish components, and additive was kneaded with a triple roll mill, whereby the conductor pastes for samples S01 to S17 were prepared.
Inorganic components: a silver powder and a borosilicate glass powder
Varnish components: ethyl cellulose resin and terpineol solvent
Additive: any one of LaB₆, SiB₆, TiB₂, TaB₂, ZrSi₂, TiSi₂, WSi₂, CrSi₂, MoSi₂, and TaSi₂

The amount of additive with respect to the amount of the inorganic components of the conductor paste was set to 15 vol.% for samples S01 to S03, S05 to S10, and S13 to S15, 9 vol.% for samples S11 and S17, and 3 vol.% for sample S12. The oxidation temperatures shown in the table were measured through the TG-DTA method.

### (2) Conductor paste for sample S18

After the surfaces of the particles of the silver powder which is an inorganic component were coated with SiB₆ which is an additive, the mixture of the above-described inorganic components and varnish components was kneaded with a triple roll mill, whereby the conductor paste for sample S18 was prepared. The amount of additive with respect to the amount of the conductor paste were 15 vol.%.

### (3) Conductor pastes for samples T01 to T03

The conductor pastes for samples T01 and T02 were prepared by the same method as that for samples S01 to S17 (missing numbers: S04 and S16) except that no additive was added. The conductor paste for sample T03 was prepared by the same method as that for samples S01 to S17 (missing numbers: S04 and S16) except that in place of the metal boride or the metal silicide, SiO₂ was added as an additive.

### <Forming and firing an unfired laminate>

(1) Vias were formed in the green sheet and filled with the conductor paste. A wiring trace was formed on a surface of the green sheet by applying the conductor paste thereto. A plurality of such green sheets with the wiring trace formed thereon were laminated to form an unfired laminate.
(2) Unfired laminates for samples T1 to T8 were fired. The firing temperature for samples S01 to S03, S05 to S12, S18, T01, and T03, which used SiO₂-B₂O₃-CaO green sheets, was set to about 850°C. The firing temperature for samples S13 to S15, S17, and T02, which used SiO₂-CaO-BaO-MgO green sheets, was set to about 900°C. The firing time was set to approximately 60 minutes for all samples S01 to S18 (missing numbers: S04 and S16) and T01 to T03.

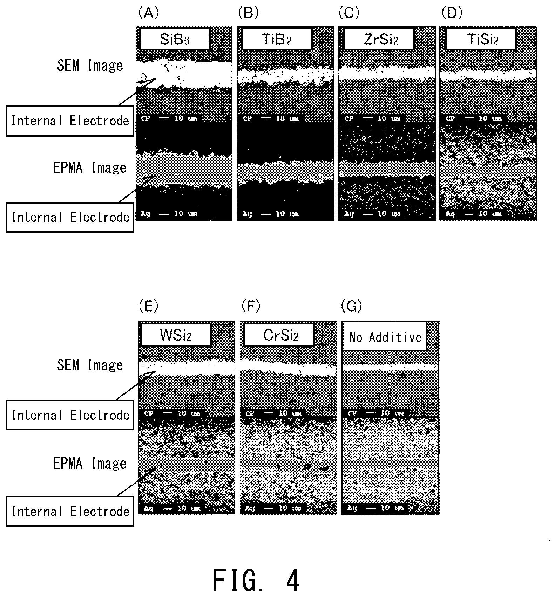

The "silver diffusion distance" shown in FIG. 3 will be described with reference to FIG. 4. Each of sections (A) to (G) of FIG. 4 shows a scanning electron microscope (SEM) image of a cross section of the LTCC substrate parallel to a direction of lamination of the LTCC substrate and an image of the same cross section as the SEM image captured by an electron probe micro analyzer (EPMA). In each section of FIG. 4, the SEM image is shown on the upper side and the image captured by EPMA is shown on the lower side. The image captured by an EPMA (hereinafter, simply referred to as the "EPMA image") shows the silver concentration distribution profile of the LTCC substrate in colors in response to the level of silver concentration. Sections (A) to (F) of FIG. 4 show the SEM images and the EPMA images of samples S02, S03, and S05 to S08 which were manufactured through use of different conductor pastes containing SiB₆, TiB₂, ZrSi₂, TiSi₂, WSi₂, and CrSi₂, respectively, as an additive. Section (G) of FIG. 4 has the SEM image and the EPMA image of sample T01 which was manufactured through use of a conductor paste containing no additive. In the center of each SEM image and each EPMA image, the internal electrode formed of the silver-based conductor extends in the horizontal direction of the images. The EPMA image shown in section (G) of FIG. 4 shows that silver diffused into a wide region extending in the vertical direction of the image from the internal electrode such that the silver concentration in the region is approximately the same as that in the internal electrode. The inventors of the present invention acquired the SEM images and the EPMA images of predetermined polished cross sections of samples S01 to S18 (missing numbers: S04 and S16), and T01 to T03. The inventor determined a "silver diffusion distance" for each sample from the EPMA image of each sample. Specifically, the inventor used the concentration of Ag at an electrode interface through which the internal electrode is in contact with the ceramic insulating layer as a reference concentration, and measured, at five points, the distance from the electrode interface to a region in which the concentration of Ag in the ceramic insulating layer becomes equal to or less than half the reference concentration. The average of the measured distances was used as the "silver diffusion distance."

The silver diffusion distances were 30 µm or less in all samples S01 to S18 (missing numbers: S04 and S16) which were manufactured through use of the conductor paste containing the metal silicide or the metal boride as an additive. By contrast, the silver diffusion distances were greater than 30 µm in samples T01 to T03 which were manufactured without use of the conductor paste containing the metal silicide or the metal boride as an additive. These results show that the metal silicide or the metal boride added to the conductor paste prevented diffusion of silver from the conductor material during firing.

If the same additive was added to the conductor paste, diffusion of silver was prevented approximately to the same degree (see samples S01 to S03 and samples S13 to S15, and samples S11 and S17) irrespective of the composition of the green sheet. The test results show that diffusion of silver was prevented to a great degree in both the case where the additive was added to the conductor paste in the form of powder and the case where the additive was added to the conductor paste as a material for coating the surfaces of the silver powder particles (see samples S01 and S18).

Particularly, the silver diffusion distance was restrained to a value smaller than 5 µm in any of samples S01 to S03, S05, S10 to S15, S17, and S18 in which one of LaB₆, SiB₆, TiB₂, TaSi₂, and ZrSi₂ was added to the conductor paste as an additive in an amount greater than 3 vol. %. It should be noted when SiB₆ is used as an additive, SiO₂ generated by oxidation during firing remains in the ceramic insulating layer. That is, in the case where SiB₆ is used as an additive as in sample S02, only a compound of the same composition as the compound contained in the ceramic insulating layer remains in the ceramic insulating layer. As a result, migration of impurities into the ceramic insulating layer is prevented.

As described above, in the manufacturing process (FIG. 2) of the present embodiment, the metal boride or the metal silicide added to the conductor paste prevents diffusion of silver from the conductor material during the firing step. Accordingly, the LTCC substrate 10 manufactured according to the manufacturing process can prevent various types of problems caused by diffusion of silver from the conductor material during the firing step such as formation of voids in the ceramic substrate, deterioration of the ceramic substrate, etc.

### B. Modifications

### B1. Modification 1

In the above-described embodiment, a single type of metal boride or a single type of metal silicide is added to the conductor paste as an additive. However, both a metal boride and a metal silicide may be added to the conductor paste as additives. A plurality of types of metal borides may be added in combination as additives. A plurality of types of metal silicides may be added in combination as additives. Alternatively, one or more types of metal borides may be added together with one or more types of metal silicides as additives.

### B2. Modification 2

In the above-described embodiment, in the process of manufacturing the LTCC substrate, at least one of a metal boride and a metal silicide is added to the conductor paste which is a silver-based conductor material. However, in a process of manufacturing a ceramic substrate other than the LTCC substrate, the additive described above may be added to a silver-based conductor material. For example, in a process of manufacturing a ceramic substrate whose firing temperature is 1000°C or higher, the additive described above may be added. The silver-based conductor material containing at least one of a metal boride and a metal silicide added thereto is not required be in the form of paste, but may be, for example, in the form of powder.

### B3. Modification 3

In the above-described embodiment, in preparation of the green sheet, alumina is used as an inorganic filler. However, as an inorganic filler used for preparation of the green sheet, a material other than alumina may be used. As an inorganic filler, for example, mullite can be used.

The present invention is not limited to the above-described embodiment, examples, and modifications, but may be embodied in various other forms without departing from the spirit of the invention. For example, in order to solve, partially or entirely, the above-mentioned problem or yield, partially or entirely, the above-mentioned effects, technical features of the embodiments, examples, and modifications corresponding to technical features of the modes described in the section "SUMMARY OF THE INVENTION" can be replaced or combined as appropriate. Also, the technical feature(s) may be eliminated as appropriate unless the present specification mentions that the technical feature(s) is mandatory.

### DESCRIPTION OF REFERENCE NUMERALS

10 ··· LTCC substrate
11 ··· ceramic insulating layer
12 ··· via electrode
13 ··· internal electrode
14 ··· external electrode

## Claims

1. A method for manufacturing a ceramic substrate containing glass, comprising a firing step of firing an unfired ceramic layer and an unfired silver-based conductor material disposed on the unfired ceramic layer, wherein the unfired silver-based conductor material contains at least one of a metal boride and a metal silicide.

2. The manufacturing method according to claim 1, wherein the metal boride is at least one of lanthanum hexaboride, silicon hexaboride, titanium diboride, and tantalum diboride.

3. The manufacturing method according to claim 1 or 2, wherein the metal silicide is at least one of titanium disilicide, zirconium disilicide, tungsten disilicide, chromium disilicide, molybdenum disilicide, and tantalum disilicide.

4. The manufacturing method according to any one of claims 1 to 3, wherein the unfired silver-based conductor material contains the metal boride or the metal silicide and the amount of the metal boride or the metal silicide with respect to the amount of the inorganic components of the unfired silver-based conductor material is greater than 3 vol.% and less than 20 vol.%.

5. The manufacturing method according to any one of claims 1 to 4, wherein the unfired silver-based conductor material contains a silver powder and at least one of the metal boride and the metal silicide is attached to surfaces of particles of the silver powder in the silver-based conductor material.

6. A ceramic substrate comprising a ceramic layer and a wiring layer of a sliver-based conductor which are formed by the firing step according to any one of claims 1 to 5.

7. A silver-based conductor material which is unfired and is fired together with an unfired ceramic layer to form a wiring layer in a ceramic substrate, wherein the unfired silver-based conductor material contains at least one of a metal boride and a metal silicide.

## Amended claims

### Amended claims under Art. 19.1 PCT

**1.** (amended) A method for manufacturing a ceramic substrate containing glass, comprising a firing step of firing an unfired ceramic layer and an unfired silver-based conductor material disposed on the unfired ceramic layer, wherein the unfired silver-based conductor material contains a metal boride.

**2.** The manufacturing method according to claim 1, wherein the metal boride is at least one of lanthanum hexaboride, silicon hexaboride, titanium diboride, and tantalum diboride.

**3.** deleted)

**4.** (amended) The manufacturing method according to claim 1 or 2, wherein the unfired silver-based conductor material contains the metal boride and the amount of the metal boride with respect to the amount of the inorganic components of the unfired silver-based conductor material is greater than 3 vol.% and less than 20 vol.%.

**5.** (amended) The manufacturing method according to any one of claims 1, 2, and 4, wherein the unfired silver-based conductor material contains a silver powder and the metal boride is attached to surfaces of particles of the silver powder in the silver-based conductor material.

**6.** (amended) A ceramic substrate comprising a ceramic layer and a wiring layer of a sliver-based conductor which are formed by the firing step according to any one of claims 1, 2, 4, and 5.

**7.** (amended) A silver-based conductor material which is unfired and is fired together with an unfired ceramic layer to form a wiring layer in a ceramic substrate, wherein the unfired silver-based conductor material contains a metal boride.

**8.** added) A method for manufacturing a ceramic substrate containing glass, comprising a firing step of firing an unfired ceramic layer and particles of an unfired silver-based conductor material disposed on the unfired ceramic layer, wherein the particles of the unfired silver-based conductor material are coated with at least one of a metal boride and a metal silicide.

Statement under Art. 19.1 PCT
Claim 1 has been amended so as to delete "at least one of" and "or metal suicide".

Claim 3 has been cancelled.

Claims 4, 5, 6 have been amended so as to conform to the amendment to claim 1 and cancellation of claim 3.

Claim 7 has also been amended so as to delete "at least one of" and "or metal suicide".

A new claim 8 has been added. The new claim 8 is based on claim 1 as filed, where "unfired silver-based conductor material" has been amended to "particles of an unfired silver-based conductor material" and "wherein the unfired silver-based conductor material contains at least one of a metal boride and a metal silicide" has been amended to "wherein the particles of the unfired silver-based conductor material are coated with at least one of a metal boride and a metal silicide". This amendment is based on paragraph [0027] of the description as filed.
